# DEMANDE DE BREVET EUROPEEN

(11) **EP 0 992 798 A1**
(43) Date de publication de la demande: **12.04.2000**
(21) Numéro de dépôt: 99402444.6
(22) Date de dépôt: 06.10.1999
(51) Int. Cl.: G01R 15/18

(54) **Agencement de mesure d'un courant alternatif du type à transformateur de courant**

(30) Priorité: 08.10.1998 FR 9812625
(71) Demandeur: CHAUVIN ARNOUX, 75018 Paris (FR)
(72) Inventeur: Arnoux, Daniel, 75018 Paris (FR); Arnoux, Axel, 75018 Paris (FR); Genter, Claude, 75018 Paris (FR)
(74) Mandataire: Berger, Helmut

(57) **Abrégé**

L'invention concerne un agencement de mesure d'un courant alternatif.

Cet agencement de mesure est du type comportant un transformateur de courant (1) du type ouvrant, telle qu'une pince ampèremétrique, et des moyens de correction de non-linéarité due notamment à des matériaux utilisés dans le transformateur (1) et dont la perméabilité varie en fonction de l'induction de travail, et délivrant un courant, image du courant primaire, qui circulant dans une charge (4) branchée sur le circuit secondaire, délivre aux bornes de celle-ci une tension proportionnelle au courant primaire. L'agencement est caractérisé en ce que la charge (4) est variable en fonction du niveau de la tension au côté secondaire (A-B) du transformateur (1), de façon à effectuer une correction de non-linéarité.

L'invention s'applique notamment aux agencements de mesure de courant alternatif.

## Description

L'invention concerne un agencement de mesure d'un courant alternatif, du type comportant un transformateur de courant, ouvrant, tel qu'une pince ampèremétrique, utilisant des matériaux dont la perméabilité varie en fonction de l'induction de travail, et délivrant un courant, image du courant primaire, qui circulant dans une charge branchée sur le circuit secondaire, délivre aux bornes de celle-ci une tension proportionnelle au courant primaire.

Des agencements de ce type sont déjà connus. La variation de perméabilité des matériaux magnétiques provoque une non-linéarité des valeurs de mesure plus ou moins importante suivant le type de matériaux ou la forme des mâchoires de la pince, entre le début et la fin du domaine de mesure du courant.

Pour pallier ce problème de la non-linéarité, on utilise généralement des matériaux magnétiques à haute perméabilité, tels que le mumétal, qui ont cependant l'inconvénient d'augmenter le coût de l'agencement de mesure.

La présente invention a pour but de proposer un agencement qui ne présente pas les inconvénients qui viennent d'être énoncés.

Pour atteindre ce but, l'agencement selon l'invention est caractérisé en ce que la charge est variable en fonction du niveau de la tension mesurée au côté secondaire du transformateur et donc du niveau du courant primaire, de façon à effectuer une correction de la non-linéarité produite par ledit matériau.

Selon une caractéristique de l'invention, la charge comporte au moins un circuit de dérivation d'une partie du courant secondaire, qui devient conducteur lorsque la tension mesurée atteint une valeur de seuil prédéterminée.

Selon une autre caractéristique de l'invention, la charge comporte une pluralité de circuits de dérivation d'une partie du courant dont les valeurs de seuil sont différentes.

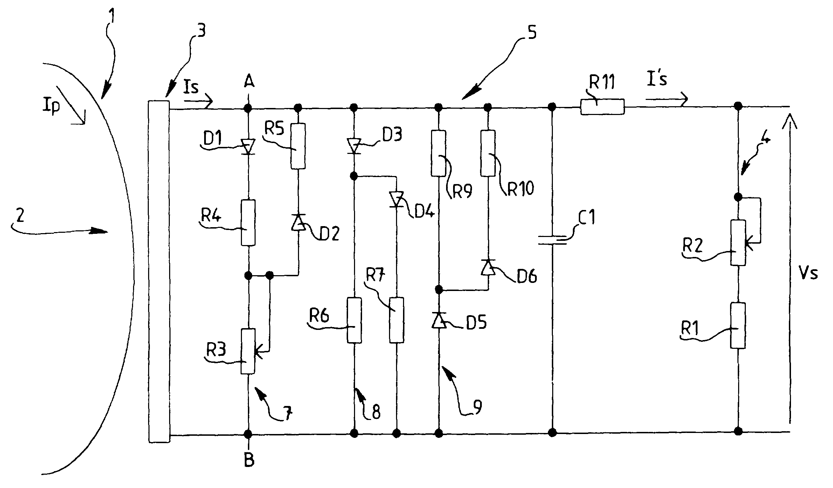

L'invention sera mieux comprise et d'autres buts, caractéristiques, détails et avantages de celle-ci apparaîtront plus clairement au cours de la description explicative qui va suivre faite en référence à la figure unique annexée donnée uniquement à titre d'exemple et donnant le schéma électrique d'un agencement selon la présente invention.

Conformément à la figure unique, l'agencement de mesure d'un courant alternatif, selon l'invention, comporte essentiellement un transformateur de courant 1 du type ouvrant, tel qu'une pince ampèremétrique, dont les côtés primaire et secondaire sont désignés respectivement par les numéros de référence 2 et 3, une charge 4 dans le circuit secondaire et un dispositif 5 de correction de la non-linéarité provoquée par la variation de la perméabilité du matériau utilisé dans le transformateur.

L'agencement est prévu pour mesurer le courant Ip circulant dans le circuit primaire 2 du transformateur et qui génère dans le circuit secondaire 3 un courant Is. L'agencement délivre la tension Vs aux bornes de la charge 4 comme tension image du courant primaire Ip. La charge 4 est formée par des résistances R1 et R2, R2 étant variable.

Le dispositif de correction 5 est réalisé sous forme de circuits de dérivation d'une partie du courant secondaire Is de façon que, lorsque les circuits de dérivation deviennent conducteurs, seulement une partie Is' s'écoule à travers la charge 4.

Le dispositif de correction 5 comporte trois circuits de dérivation de courant 7, 8, 9 qui sont montés parallèles entre les bornes A et B de l'enroulement secondaire 3 du transformateur 1.

Le circuit 7 comporte une résistance réglable R3 qui est montée en série avec un montage en parallèle de montages en série, d'une part, d'une résistance R4 et d'une diode D1, et, d'autre part, d'une résistance R5 et d'une diode D2. Les deux diodes sont polarisées dans des sens inverses de façon que le circuit de dérivation 7 puisse être efficace pour les deux alternances du courant Is.

Le circuit de dérivation 8 comporte une diode D3 disposée en série avec un montage en parallèle d'une résistance R6, d'une part, et, d'autre part, d'une résistance R7 et d'une diode D4 montées en série. Le circuit de dérivation 9 présente la même structure que le circuit 8 et comporte donc des diodes D5 et D6 ainsi que des résistances R9 et R10, les diodes D5 et D6 étant polarisées dans des sens opposés aux diodes D3 et D4 du circuit 8 pour le passage des deux alternances du courant secondaire.

Concernant les résistances, leurs valeurs sont choisies de façon que le courant, par exemple de quelque µA auquel les diodes deviennent conductrices, soit atteint dans les différents circuits de dérivation à des valeurs de tension de seuil de conduction prédéterminées entre les points A/B, qui sont spécifiques aux différents circuits.

Il est encore à noter qu'une résistance R11 est montée en série avec la charge 4 pour permettre l'augmentation de la tension entre les bornes A et B pour que la plage de correction soit plus importante et permette au final une réduction progressive de la charge secondaire globale, tout en conservant la même valeur de la tension Vs pour un courant Ip donné. De plus, un condensateur C1 est monté en parallèle sur les circuits de dérivation et sert à diminuer le déphasage entre la tension Vs et le courant Ip, augmenté par le rajout de la résistance R11.

Les diodes peuvent être choisies à faible seuil de conduction. Elles pourraient être du type Schottky de façon à ce que la correction puisse s'effectuer le plus tôt possible dans le domaine de mesure.

Concernant le fonctionnement de l'agencement, à faible courant Ip et donc Is, la tension présente entre les bornes A et B n'est pas suffisante pour rendre conductrice les diodes D1 à D6. Par conséquent, l'intégralité du courant Is passe dans la charge 4 formée par les résistances R1 et R2. Is est donc égal à Is'. On pourrait effectuer un réglage de la résistance R2 à ce bas niveau de courant.

Au fur et à mesure de l'augmentation de la tension entre les bornes A et B, les diodes D1 à D6 vont conduire pour dériver une partie du courant secondaire Is dans les résistances R3 à R10. Par conséquent le courant Is' est inférieur au courant Is. La résistance réglable R3 permet un réglage de la fin d'échelle de mesure.

Par conséquent, l'agencement selon l'invention permet de réaliser une correction de la non linéarité en faisant varier le courant Is' en fonction du niveau de la tension mesurée. Par exemple si la non-linéarité entre le début et la fin du domaine de mesure représente 10 %, on pourrait faire en sorte que la charge résistive effective soit 10 % plus importante à faible courant qu'au courant nominal. Ceci est effectué par une mise en parallèle sur la charge, successivement, d'autres charges formées par les résistances se trouvant dans des circuits de dérivation. Cette dérivation d'une partie du courant Is, vue de la sortie de l'agencement, correspond à une diminution de la charge de la pince lorsque le courant Is augmente. Bien entendu la qualité de la correction peut être améliorée en choisissant un nombre approprié de circuits de dérivation. Autrement dit, le nombre des circuits de dérivation, c'est-à-dire de cellules de correction du type à diode-résistance, peut être augmenté ou diminué suivant la correction à effectuer.

Il est à noter qu'à la place des diodes tout autre élément semi-conducteur ou montage électronique équivalent peut être utilisé. On pourrait prévoir à cette fin des interrupteurs commandés par un comparateur de la tension mesurée aux valeurs de tension de seuil de conduction des circuits de dérivation et qui pourraient alors rendre ces circuits brusquement conducteurs.

De façon gnérale, l'agencement selon l'invention est adapté pour réaliser une correction quelconque, dépendant du type de variation souhaitée du rapport de transformation existant entre le courant primaire Ip et le courant secondaire Is.

## Revendications

1. Agencement de mesure d'un courant alternatif, du type comportant un transformateur de courant, du type ouvrant, telle qu'une pince ampèremétrique, et des moyens de correction de non-linéarité due notamment à des matériaux utilisés dans le transformateur et dont la perméabilité varie en fonction de l'induction de travail, et délivrant un courant, image du courant primaire, qui circulant dans une charge branchée sur le circuit secondaire, délivre aux bornes de celle-ci une tension porportionnelle au courant primaire, caractérisé en ce que la charge (4) est variable en fonction du niveau de la tension au côté secondaire (A-B) du transformateur (1), de façon à effectuer une correction de non-linéarité, et en ce que la charge comporte au moins un circuit de dérivation (7, 8, 9) d'une partie du courant secondaire (Is), qui devient conducteur lorsque la tension mesurée (A-B) atteint une valeur de seuil prédéterminé.

2. Agencement selon la revendication 1, caractérisé en ce que la charge comporte une pluralité de circuits de dérivation (7, 8, 9) d'une partie du courant Is, dont les valeurs de seuil sont différentes.

3. Agencement selon la revendication 2, caractérisé en ce que le nombre de circuits de dérivation est choisi en fonction de la qualité de la correction de la non-linéarité, qui est souhaitée.

4. Agencement selon l'une des revendications précédentes, caractérisé en ce qu'un circuit de dérivation (7, 8, 9) comporte un élément semi-conducteur à seuil de conduction prédéterminé.

5. Agencement selon la revendication 4, caractérisé en ce que le circuit de dérivation (7, 8, 9) comporte un élément semi-conducteur (D1- D6), tel qu'une diode, et, montée en série avec celui-ci, une résistance (R3-R10) choisie de façon à ce qu'à la valeur prédéterminée de la tension mesurée, circule dans le circuit le courant déclenchant la conduction dudit élément.

6. Agencement selon la revendication 5, caractérisé en ce que l'élément semi-conducteur (D1-D6) est une diode du type à faible seuil de conduction, tel qu'une diode Schottky

7. Agencement selon la revendication 4, caractérisé en ce que l'élément semi-conducteur est un interrupteur commandé par un comparateur de la tension mesurée à la tension de seuil à laquelle le circuit doit devenir conducteur.

8. Agencement selon l'une des revendications précédentes, caractérisé en ce que la charge 4 comporte une résistance de réglage (R2) lorsque les circuits de dérivation sont à l'état non conducteur.

9. Agencement selon l'une des revendications précédentes, caractérisé en ce qu'il comporte des moyens (R3) de réglage de la fin d'échelle dans un circuit de dérivation.

10. Agencement selon l'une des revendications précédentes, caractérisé en ce qu'il est adapté pour réaliser une correction quelconque, dépendant du type de variation souhaitée du rapport de transformation existant entre le courant primaire Ip et le courant secondaire Is.
